# EUROPEAN PATENT APPLICATION

(11) **EP 4 611 048 A1**
(43) Date of publication of application: **03.09.2025**
(21) Application number: 24794326.9
(22) Date of filing: 22.04.2024
(51) Int. Cl.: H01L 31/075

(54) **SOLAR CELL AND PREPARATION METHOD THEREFOR, PHOTOVOLTAIC MODULE AND PHOTOVOLTAIC SYSTEM**

(30) Priority: 19.01.2024 CN 202410084669
(71) Applicant: Yangtze Institute for Solar Technology, Wuxi, Jiangsu 214437 (CN); Kunshan Bluesky Electronic Materials Co., Ltd, Suzhou, Jiangsu 215399 (CN)
(72) Inventor: SHEN, Hui, Jiangsu 214437 (CN); ZHU, Guangxia, Jiangsu 214437 (CN)
(74) Representative: V.O.
(86) International application number: PCT/CN2024/089004
(87) International publication number: WO 2025/152287

(57) **Abstract**

The present application relates to a solar cell and a manufacturing method thereof, a photovoltaic module, and a photovoltaic system. The solar cell (1) includes: an intrinsic semiconductor substrate (111) including an intrinsic region (111a), a first surface (111b) and a second surface (111c), the first surface (111b) and the second surface (111c) being provided on two opposite sides of the intrinsic semiconductor substrate (111), and the intrinsic region (111a) being provided between the first surface (111b) and the second surface (111c); a first doped structure (112) having a first doping type, and provided at a side of the intrinsic region (111a) adjacent to the first surface (111b); and a second doped structure (113) having a second doping type and provided at a side of the intrinsic region (111a) adjacent to the second surface (111c). The first doping type is opposite to the second doping type, and the first doped structure (112), the intrinsic region (111a) and the second doped structure (113) form a p-i-n structure.

## Description

### CROSS-REFERENCE TO RELATED APPLICATIONS

This application claims priority to Chinese patent application No. 2024100846697, filed on January 19, 2024, entitled "Solar cell and manufacturing method thereof, photovoltaic module, and photovoltaic system", the content of which is hereby incorporated by reference in its entirety.

### TECHNICAL FIELD

The present application relates to the field of solar cell technology, and in particular, to a solar cell and a manufacturing method thereof, a photovoltaic module, and a photovoltaic system.

### BACKGROUND

A solar cell is a device that directly converts light energy into electrical energy through the photoelectric effect. Generally speaking, a solar cell is manufactured on a semiconductor wafer or substrate by using semiconductor processing technology to form a p-n junction near the surface of the substrate.

Silicon substrates of solar cells generally adopt p-type silicon substrate or n-type silicon substrate. Regardless of whether it is a p-type silicon substrate or an n-type silicon substrate, relevant elements need to be doped during the growth process of silicon single crystals. Due to the complex growth process of silicon single crystals, the doped elements are distributed differently in the radial or longitudinal direction of the silicon single crystals, resulting in different resistivities of silicon wafers cut from the same silicon rod. Moreover, for a single silicon wafer, the resistivity from the center of the silicon wafer to the edge of the silicon wafer can also be different. This will not only complicate the manufacturing process of the solar cell, but also affect the conversion efficiency of the solar cell.

### SUMMARY

Accordingly, it is necessary to provide a solar cell and a manufacturing method thereof, a photovoltaic module, and a photovoltaic system to address the above problems.

In a first aspect, an embodiment of the present application provides a solar cell, including:
an intrinsic semiconductor substrate including an intrinsic region, a first surface and a second surface, the first surface and the second surface being provided on opposite sides of the intrinsic semiconductor substrate, and the intrinsic region being provided between the first surface and the second surface;
a first doped structure having a first doping type, the first doped structure being provided on a side of the intrinsic region adjacent to the first surface; and
a second doped structure having a second doping type, the second doped structure being provided on a side of the intrinsic region adjacent to the second surface.

The first doping type is opposite to the second doping type, and the first doped structure, the intrinsic region and the second doped structure form a p-i-n structure.

In an embodiment, a resistivity of the intrinsic region is greater than 100 Ω·cm.

And/or, a doped concentration of a p-type dopant in the intrinsic region is less than or equal to 1.3×10¹⁴ cm⁻³, and a doped concentration of a n-type dopant in the intrinsic region is less than or equal to 4.4×10¹³ cm⁻³.

In an embodiment, a thickness of the intrinsic semiconductor substrate is in a range of 50 µm to 300 µm.

In an embodiment, a doped concentration of the first doped structure is in a range of 3×10¹⁸ cm⁻³ to 5×10²⁰ cm⁻³.

And/or, a doped concentration of the second doped structure is in a range of 3×10¹⁸ cm⁻³ to 5×10²⁰ cm³.

In an embodiment, a first dimension is defined between a side of the first doped structure adjacent to the first surface and a side of the first doped structure away from the first surface, and the first dimension is in a range of 5 nm to 5000 nm.

And/or, a second dimension is defined between a side of the second doped structure adjacent to the first surface and a side of the second doped structure away from the first surface, and the second dimension is in a range of 5 nm to 5000 nm.

In an embodiment, the solar cell further includes a third doped structure. The third doped structure has the second doping type and is provided on a side of the first doped structure away from the intrinsic region.

The third doped structure and the first doped structure form a p-n junction.

In an embodiment, the solar cell further includes a fourth doped structure. The fourth doped structure has the first doping type and is provided on a side of the second doped structure away from the intrinsic region.

The fourth doped structure and the second doped structure form a p-n junction.

In an embodiment, the first doped structure is embedded in the intrinsic semiconductor substrate and is located between the intrinsic region and the first surface.

In an embodiment, the second doped structure is embedded in the intrinsic semiconductor substrate and is located between the intrinsic region and the second surface.

In an embodiment, the second doped structure is provided on a side of the second surface away from the first surface.

In an embodiment, the solar cell further includes a first tunneling layer provided on the second surface. The second doped structure is provided on a side of the first tunneling layer away from the first surface.

In an embodiment, the solar cell further includes:
a first passivation anti-reflection layer provided on a side of the first doped structure away from the intrinsic region;
a first electrode provided on a side of the first doped structure away from the second doped structure, the first electrode extending through the first passivation anti-reflection layer and being electrically connected to the first doped structure;
a second passivation anti-reflection layer provided on a side of the second doped structure away from the intrinsic region; and
a second electrode provided on a side of the second doped structure away from the first doped structure, the second electrode extending through the second passivation anti-reflection layer, and being electrically connected to the second doped structure.

In an embodiment, the first doped structure is provided on a side of the first surface away from the second surface.

In an embodiment, the second doped structure is provided on a side of the second surface away from the first surface.

In an embodiment, the solar cell further includes: a first intrinsic semiconductor layer provided on the first surface, the first doped structure being provided on a side of the first intrinsic semiconductor layer away from the second surface; and
a second intrinsic semiconductor layer provided on the second surface, the second doped structure being provided on a side of the second intrinsic semiconductor layer away from the first surface.

In an embodiment, the solar cell further includes:
a first transparent conductive layer provided on a side of the first doped structure away from the first intrinsic semiconductor layer;
a first electrode provided on a side of the first transparent conductive layer away from the first intrinsic semiconductor layer and being electrically connected to the first transparent conductive layer;
a second transparent conductive layer provided on a side of the second doped structure away from the second intrinsic semiconductor layer; and
a second electrode provided on a side of the second transparent conductive layer away from the second intrinsic semiconductor layer and being electrically connected to the second transparent conductive layer.

In an embodiment, the solar cell further includes:
a second tunneling layer provided on the first surface, the first doped structure being provided on a side of the second tunneling layer away from the second surface; and
a third tunneling layer provided on the second surface, the second doped structure being provided on a side of the third tunneling layer away from the first surface.

In a second aspect, an embodiment of the present application provides another solar cell, including:
an intrinsic semiconductor substrate having a first surface and a second surface that are arranged opposite to each other, a first conductive region and a second conductive region that are arranged in a first direction being provided on the intrinsic semiconductor substrate, and the first direction being perpendicular to a thickness direction of the intrinsic semiconductor substrate;
a first passivation layer provided on the first surface and located in the first conductive region;
a second passivation layer provided on the first surface and located in the second conductive region;
a first doped structure having a first doping type and provided on a side of the first passivation layer away from the intrinsic semiconductor substrate; and
a second doped structure having a second doping type and provided on a side of the second passivation layer away from the intrinsic semiconductor substrate.

The first doping type is opposite to the second doping type, and the first doped structure, the intrinsic semiconductor substrate and the second doped structure form a p-i-n structure.

In an embodiment, a resistivity of the intrinsic semiconductor substrate is greater than 100 Ω·cm.

In an embodiment, a doped concentration of a p-type dopant in the intrinsic semiconductor substrate is less than or equal to 1.3×10¹⁴ cm⁻³, and a doped concentration of a n-type dopant in the intrinsic semiconductor substrate is less than or equal to 4.4×10¹³ cm⁻³.

In an embodiment, a thickness of the intrinsic semiconductor substrate is in a range of 50 µm to 300 µm.

In an embodiment, a doped concentration of the first doped structure is in a range of 3×10¹⁸ cm⁻³ to 5×10²⁰ cm⁻³.

And/or, a doped concentration of the second doped structure is in a range of 3×10¹⁸ cm⁻³ to 5×10²⁰ cm⁻³.

In an embodiment, a third dimension is defined between a side of the first doped structure adjacent to the first surface and a side of the first doped structure away from the first surface, and the third dimension is in a range of 5 nm to 5000 nm.

And/or, a fourth dimension is defined between a side of the second doped structure adjacent to the first surface and a side of the second doped structure away from the first surface, and the fourth dimension is in a range of 5 nm to 5000 nm.

In an embodiment, the solar cell further includes a third doped structure. The third doped structure has the second doping type and is provided on a side of the first doped structure away from the intrinsic semiconductor substrate.

The third doped structure and the first doped structure form a p-n junction

In an embodiment, the solar cell further includes a fourth doped structure. The fourth doped structure has the first doping type and is provided on a side of the second doped structure away from the intrinsic semiconductor substrate.

The fourth doped structure and the second doped structure form a p-n junction.

In an embodiment, the first passivation layer and the second passivation layer are configured as tunneling dielectric layers.

And/or, the first doped structure and the second doped structure are made of a material including polysilicon.

In an embodiment, the first passivation layer and the second passivation layer are made of a material including an intrinsic semiconductor material.

And/or, the first doped structure and the second doped structure are made of a material including microcrystalline silicon or amorphous silicon.

In an embodiment, the solar cell further includes:
a first anti-reflection layer provided on a side of the first doped structure away from the intrinsic semiconductor substrate, and on a side of the second doped structure away from the intrinsic semiconductor substrate;
a first electrode provided on a side of the first doped structure away from the intrinsic semiconductor substrate, the first electrode extending through the first anti-reflection layer and being electrically connected to the first doped structure;
a second electrode provided on a side of the second doped structure away from the intrinsic semiconductor substrate, the second electrode extending through the first anti-reflection layer and being electrically connected to the second doped structure;
a third passivation layer provided on the second surface; and
a second anti-reflection layer provided on a side of the third passivation layer away from the intrinsic semiconductor substrate.

In a third aspect, an embodiment of the present application provides a manufacturing method of a solar cell, including:
providing an intrinsic semiconductor substrate, the intrinsic semiconductor substrate including an intrinsic region, a first surface and a second surface, the first surface and the second surface being provided on opposite sides of the intrinsic semiconductor substrate, and the intrinsic region being provided between the first surface and the second surface; and
forming a first doped structure and a second doped structure on the intrinsic semiconductor substrate. The first doped structure has a first doping type and is provided on a side of the intrinsic region adjacent to the first surface; the second doped structure has a second doping type and is provided on a side of the intrinsic region adjacent to the second surface. The first doping type is opposite to the second doping type. The first doped structure, the intrinsic region and the second doped structure form a p-i-n structure.

In a fourth aspect, an embodiment of the present application provides a manufacturing method of a solar cell, including:
providing an intrinsic semiconductor substrate, the intrinsic semiconductor substrate having a first surface and a second surface that are arranged opposite to each other, a first conductive region and a second conductive region that are arranged in a first direction being provided on the intrinsic semiconductor substrate, and the first direction being perpendicular to a thickness direction of the intrinsic semiconductor substrate;
forming a first passivation layer on the first surface, and forming a first doped structure on a side of the first passivation layer away from the intrinsic semiconductor substrate, the first passivation layer being located in the first conductive region, and the first doped structure having a first doping type; and
forming a second passivation layer on the first surface, and forming a second doped structure on a side of the second passivation layer away from the intrinsic semiconductor substrate. The second passivation layer is located in the second conductive region, the second doped structure has a second doping type. The first doping type is opposite to the second doping type. The first doped structure, the intrinsic semiconductor substrate and the second doped structure form a p-i-n structure.

In a fifth aspect, an embodiment of the present application provides a photovoltaic module, including the solar cell according to any one of the embodiments of the first aspect and the second aspect.

In a sixth aspect, an embodiment of the present application provides a photovoltaic system, including the photovoltaic module in the fifth aspect.

The details of one or more embodiments of the present application are set forth in the following drawings and description. Other features, objects, and advantages of the present application will become apparent from the description, drawings, and claims.

### BRIEF DESCRIPTION OF THE DRAWINGS

In order to illustrate technical solutions in the embodiments of the present application or in the prior art more clearly, the drawings used in the embodiments or in the prior art will be described briefly. Apparently, the following described drawings are merely for the embodiments of the present application, and other drawings can be derived by those of ordinary skill in the art without any creative effort.
FIG. 1 is a partial cross-sectional schematic view of a solar cell according to an embodiment of the present application.
FIG. 2 is a partial cross-sectional schematic view of a solar cell according to another embodiment of the present application.
FIG. 3 is a partial cross-sectional schematic view of a solar cell according to yet another embodiment of the present application.
FIG. 4 is a partial cross-sectional schematic view of a solar cell according to a still further embodiment of the present application.
FIG. 5 is a partial cross-sectional schematic view of a solar cell according to a still further embodiment of the present application.
FIG. 6 is a partial cross-sectional schematic view of a solar cell according to a still further embodiment of the present application.
FIG. 7 is a partial cross-sectional schematic view of a solar cell according to a still further embodiment of the present application.
FIG. 8 is a partial cross-sectional schematic view of a solar cell according to a still further embodiment of the present application.
FIG. 9 is a schematic flowchart of a manufacturing method of a solar cell according to an embodiment of the present application.
FIG. 10 is a schematic flowchart of a manufacturing method of a solar cell according to an embodiment of the present application.

### Reference numerals:

1. Solar cell; 111. Semiconductor substrate; 111a. Intrinsic region; 111b. First surface; 111c. Second surface; 111d. First conductive region; 111e. Second conductive region; 112. First doped structure; 113. Second doped structure; 114. First tunneling layer; 115. First passivation anti-reflection layer; 116. Second passivation anti-reflection layer; 117. First electrode; 118. Second electrode; 119. First intrinsic semiconductor layer; 120. Second intrinsic semiconductor layer; 121. First transparent conductive layer; 122. Second transparent conductive layer; 123. Second tunneling layer; 124. Third tunneling layer; 125. First passivation layer; 126. Second passivation layer; 127. First anti-reflection layer; 128. Second anti-reflection layer; 129. Third passivation layer; 130. Third doped structure; 131. Fourth doped structure.

### DETAILED DESCRIPTION OF THE EMBODIMENTS

The technical solutions in the embodiments of the present application will be clearly and completely described below with reference to the accompanying drawings in the embodiments of the present application. Obviously, the described embodiments are only some of the embodiments of the present application, rather than all of the embodiments. Based on the embodiments in the present application, all other embodiments obtained by those of ordinary skill in the art without creative efforts fall within the scope of protection of the present application.

Unless otherwise defined, all technical and scientific terms used herein have the same meaning as those commonly understood by those skilled in the art to which the present application belongs. The terms used herein in the specification of the present application are only for the purpose of describing specific embodiments and are not intended to limit the present application.

It should be understood that when an element or layer is referred to as "on...", "adjacent to...", "connected to" or "coupled to" other elements or layers, it can be directly on, adjacent to, connected to or coupled to the other elements or layers, or there can be intermediate elements or layers. On the contrary, when an element is referred to as "directly on...", "directly adjacent to...", "directly connected to" or "directly coupled to" other elements or layers, there is no intermediate element or layer. It should be understood that although the terms first, second, third, etc. can be used to describe various elements, components, regions, layers, doping types and/or parts, these elements, components, regions, layers, doping types and/or parts should not be limited by these terms. These terms are only used to distinguish one element, component, region, layer, doping type or part from another element, component, region, layer, doping type or part. Therefore, without departing from the teachings of the present application, the first element, component, region, layer, doping type or part discussed below can be represented as a second element, component, region, layer or part.

Spatially relative terms such as "under", "beneath", "below", "on the bottom of", "on the top of", "above", and the like may be used herein to describe the relationship between an element or feature shown in the figures to other elements or features. It should be understood that, in addition to the orientations shown in the figures, spatially relative terms also include different orientations of the device in use and operation. For example, if the device in the accompanying drawings is flipped, an element or feature described as "under", "beneath", or "below" other elements or features will be oriented as being "above" the other elements or features. Thus, the exemplary terms "under" and "below" may include both upper and lower orientations. In addition, the device may also be orientated additionally (e.g., rotated 90 degrees or orientated in other ways), and the spatial descriptors used herein are interpreted accordingly.

When used herein, the singular forms "a", "an", and "aid/the" may also include plural forms, unless the context clearly indicates otherwise. It should also be understood that the terms "include/comprise" or "have" and the like specify the presence of stated features, integers, steps, operations, components, parts, or combinations thereof, but do not exclude the possibility of the presence or addition of one or more other features, integers, steps, operations, components, parts, or combinations thereof. In addition, in this specification, the term "and/or" includes any and all combinations of the associated listed items.

Embodiments of the present application are described herein with reference to cross-sectional views that are schematic views of ideal embodiments (and intermediate structures) of the present application, so that variants in the shapes shown due to, for example, manufacturing techniques and/or tolerances can be expected. Therefore, embodiments of present application should not be limited to the specific shapes of the regions shown herein, and includes shape deviations due to, for example, manufacturing techniques. For example, an injection region shown as a rectangle generally has rounded or curved features and/or an injected concentration gradient at its edges, rather than a binary change from the injection region to a non- injection region. Similarly, a buried region formed by injection may result in some injections in the region between the buried region and the surface through which the injection is performed. Therefore, the regions shown in the figures are schematic in nature, their shapes do not represent the actual shape of the region of the device, and do not limit the scope of the application.

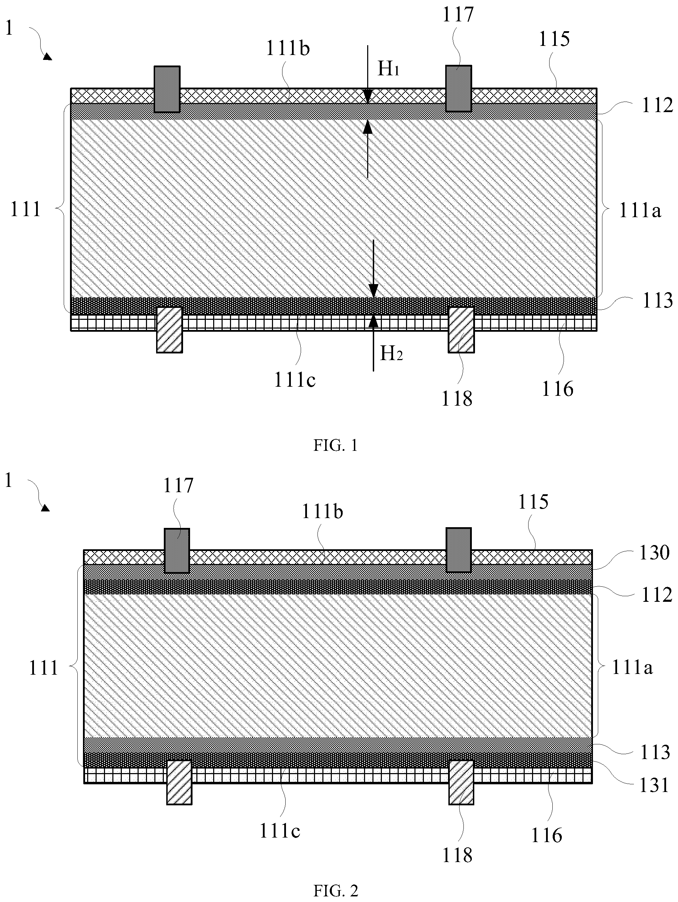

In a first aspect, as shown in FIG. 1, an embodiment of the present application provides a solar cell 1, which may be a Passivated Emitter Rear Totally-diffused (PERT) cell, a Tunnel Oxide Passivated Contact (TOPCon) cell, a Silicon Hetero Junction (SHJ) cell, a tandem cell, or the like.

Specifically, the solar cell 1 includes an intrinsic semiconductor substrate 111, a first doped structure 112, and a second doped structure 113. The intrinsic semiconductor substrate 111 includes an intrinsic region 111a, a first surface 111b, and a second surface 111c. The first surface 111b and the second surface 111c are provided on opposite sides of the intrinsic semiconductor substrate 111. The intrinsic region 111a is provided between the first surface 111b and the second surface 111c. Here, the first surface 111b may be one of a light-facing surface and a back-light surface of the solar cell 1, and the second surface 111c may be another of the light-facing surface and the back-light surface of the solar cell 1.

Further, the first doped structure 112 has a first doping type, and is provided on a side of the intrinsic region 111a adjacent to the first surface 111b. The second doped structure 113 has a second doping type, and is provided on a side of the intrinsic region 111a adjacent to the second surface 111c. The first doping type is opposite to the second doping type. The first doped structure 112, the intrinsic region 111a, and the second doped structure 113 form a p-i-n structure. It should be understood that in an example, the first doping type is p-type, and the second doping type is n-type. In an opposite example, the first doping type is n-type, and the second doping type is p-type.

It should be noted that the first doped structure 112 and the second doped structure 113 may be a doped region provided on the intrinsic semiconductor substrate 111, or may be a film layer structure containing a dopant. When at least one of the first doped structure 112 and the second doped structure 113 is a doped region provided on the intrinsic semiconductor substrate 111, the intrinsic region 111a is a partial region of the intrinsic semiconductor substrate 111. When both the first doped structure 112 and the second doped structure 113 are film layer structures containing a dopant, the intrinsic region 111a is the entire region of the intrinsic semiconductor substrate 111.

In the solar cell 1 according to the embodiments of the present application, by disposing the intrinsic region 111a on the intrinsic semiconductor substrate 111, and disposing the first doped structure 112 and the second doped structure 113 on opposite sides of the intrinsic region 111a, the first doped structure 112, the intrinsic region 111a and the second doped structure 113 form the p-i-n structure. As such, compared with the conventional technology of using a p-type or n-type semiconductor substrate 111 to manufacture a solar cell 1, the substrate of the solar cell 1 according to the embodiment of the present application adopts the intrinsic semiconductor substrate 111 including the intrinsic region 111a, therefore, during the process of manufacturing a blank (such as a silicon rod) of the intrinsic semiconductor substrate 111, it is not necessary to dope a p-type or n-type dopant, which, on the one hand, is beneficial to reduce the complexity of the manufacturing process of the solar cell 1, on the other hand, is more beneficial to the growth of silicon crystals, can reduce the dislocation density in the silicon crystals, increase the crystal pulling speed, and reduce the defect density. Furthermore, after the silicon rod is cut into wafers, there is no resistivity difference in the radial and longitudinal directions of the intrinsic silicon wafer, which, on the one hand, is beneficial to improve the electrical consistency of the silicon wafer, thereby improving the conversion efficiency of the solar cell 1; on the other hand, is beneficial to improve the utilization rate of the silicon rod, thereby reducing the manufacturing cost of the solar cell 1.

Here, it should also be noted that the solar cell 1 according to the embodiment of the present application has a p-i junction and an i-n junction provided on both sides of the intrinsic semiconductor substrate 111, respectively. With such a structure, the carrier can have a better separation effect, thereby improving the photoelectric conversion efficiency of the solar cell 1. Specifically, compared with the substrate of the conventional solar cell 1, since the intrinsic semiconductor substrate 111 in the embodiment of the present application includes the intrinsic region 111a, the doped concentration of the intrinsic semiconductor substrate 111 is much lower than the doped concentration of the conventional substrate. Moreover, because the lower the doped concentration of the substrate, the deeper the built-in electric field of the solar cell 1 extends into the substrate, therefore, the built-in electric field of the solar cell 1 in the embodiment of the present application extends deeper into the substrate, and has a larger influence range, thereby improving the separation effect of the carriers.

In an embodiment, the resistivity of the intrinsic region 111a is greater than 100 Ω·cm. In other words, the content of the dopant in the intrinsic region 111a is particularly small. As such, it is beneficial to increase the depth of the built-in electric field extending into the intrinsic semiconductor substrate 111, thereby helping to improve the separation effect of the carriers.

In an embodiment, the doped concentration of the p-type dopant in the intrinsic region 111a is less than or equal to 1.3×10¹⁴ cm⁻³, and the doped concentration of the n-type dopant in the intrinsic region 111a is less than or equal to 4.4×10¹³ cm⁻³. In this way, the content of the dopant in the intrinsic region 111a is particularly small. As such, it is beneficial to increase the depth of the built-in electric field extending into the intrinsic semiconductor substrate 111, thereby helping to improve the separation effect of carriers.

In an embodiment, the thickness of the intrinsic semiconductor substrate 111 is in a range of 50 µm to 300 µm. For example, the thickness of the intrinsic semiconductor substrate 111 may be 50 µm, 60 µm, 65 µm, 80 µm, 100 µm, 130 µm, 160 µm, 190 µm, 230 µm, 270 µm, 290 µm, 300 µm, or between any two of the above values. By configuring the thickness of the intrinsic semiconductor substrate 111 to be within the above range, it is beneficial to reduce the thickness of the solar cell 1 on the one hand, and to form a stable p-i-n structure on the other hand.

In an embodiment, the doped concentration of the first doped structure 112 is in a range of 3×10¹⁸ cm⁻³ to 5×10²⁰ cm⁻³. For example, the doped concentration of the first doped structure 112 may be 3×10¹⁸ cm⁻³, 5×10¹⁸ cm⁻³, 1×10¹⁹ cm⁻³, 5×10²⁰ cm⁻³, or between any two of the above values. By configuring the doped concentration of the first doped structure 112 to be within the above range, on the one hand, it is beneficial to reduce the manufacturing cost, on the other hand, the first doped structure 112 can have a better conductivity.

In an embodiment, the doped concentration of the second doped structure 113 is in a range of 3×10¹⁸ cm⁻³ to 5×10²⁰ cm⁻³. For example, the doped concentration of the second doped structure 113 may be 3×10¹⁸ cm⁻³ , 5×10¹⁸ cm⁻³, 1×10¹⁹ cm⁻³ , 5×10²⁰ cm⁻³, or between any two of the above values. By configuring the doped concentration of the second doped structure 113 to be within the above range, on the one hand, it is beneficial to reduce the manufacturing cost, and on the other hand, the second doped structure 113 can have a better conductivity.

In an embodiment, as shown in FIG. 1, a first dimension H₁ is defined between a side of the first doped structure 112 adjacent to the first surface 111b and a side of the first doped structure 112 away from the first surface 111b, where the first dimension H₁ is in a range of 5 nm to 5000 nm. For example, the first dimension H₁ may be 5 nm, 10 nm, 100 nm, 1500 nm, 2500 nm, 3000 nm, 4000 nm, 5000 nm, or between any two of the above values. By configuring the first dimension H₁ to be within the above range, it is beneficial to reduce manufacturing costs on the one hand, and to form a stable p-i-n structure on the other hand.

In an embodiment, as shown in FIG. 1, a second dimension H₂ is defined between a side of the second doped structure 113 adjacent to the first surface 111b and a side of the second doped structure 113 away from the first surface 111b, where the second dimension H₂ is in a range of 5 nm to 5000 nm. For example, the second dimension H₂ may be 5 nm, 10 nm, 100 nm, 1500 nm, 2500 nm, 3000 nm, 4000 nm, 5000 nm, or between any two of the above values. By configuring the second dimension H₂ to be within the above range, it is beneficial to reduce manufacturing costs on the one hand, and to form a stable p-i-n structure on the other hand.

In an embodiment, as shown in FIG. 2, the solar cell 1 further includes a third doped structure 130. The third doped structure 130 has a second doping type and is provided on a side of the first doped structure 112 away from the intrinsic region 111a. The third doped structure 130 and the first doped structure 112 form a p-n junction. By providing the third doped structure 130, it is beneficial to increase the doped concentration of the contact interface between a first electrode 117 and the intrinsic semiconductor substrate 111, thereby reducing the contact resistance of the contact interface between the first electrode 117 and the intrinsic semiconductor substrate 111, thereby improving the efficiency of the solar cell 1.

In an embodiment, the solar cell 1 further includes a fourth doped structure 131. The fourth doped structure 131 has the first doping type and is provided on a side of the second doped structure 113 away from the intrinsic region 111a. The fourth doped structure 131 and the second doped structure 113 form a p-n junction. By providing the fourth doped structure 131, it is beneficial to increase the doped concentration of the contact interface between the second electrode 118 and the intrinsic semiconductor substrate 111, thereby reducing the contact resistance of the contact interface between the second electrode 118 and the intrinsic semiconductor substrate 111, thereby improving the efficiency of the solar cell 1.

In an embodiment, as shown in FIGS. 1, 2, 3 and 4, the first doped structure 112 is embedded in the intrinsic semiconductor substrate 111 and is located between the intrinsic region 111a and the first surface 111b. Specifically, a first doped region is provided in the intrinsic semiconductor substrate 111. The first doped region is doped with a dopant of a first doping type, and the first doped region is the first doped structure 112.

In an embodiment, the first doped region may be formed by diffusion from the first surface 111b toward the second surface 111c. The doping depth of the first doped region may be in a range of 0.1 µm to 3 µm. The doped concentration of the first doped region may be in a range of 3×10¹⁸ cm⁻³ to 5×10²⁰ cm⁻³.

In an embodiment, the doped concentration of the first doped region gradually decreases from the first surface 111b to the second surface 111c.

In an embodiment, as shown in FIGS. 1 and 2, the second doped structure 113 is embedded in the intrinsic semiconductor substrate 111 and is located between the intrinsic region 111a and the second surface 111c. Specifically, a second doped region is provided in the intrinsic semiconductor substrate 111. The second doped region is doped with a dopant of a second doping type, and the second doped region is the second doped structure 113.

In an embodiment, the second doped region may be formed by diffusion from the second surface 111c toward the first surface 111b. The doping depth of the second doped region may be in a range of 0.1 µm to 3 µm. The doped concentration of the second doped region may be in a range of 3×10¹⁸ cm⁻³ to 5×10²⁰ cm⁻³.

In an embodiment, the doped concentration of the second doped region gradually decreases from the second surface 111c to the first surface 111b.

In an embodiment, as shown in FIG. 2, the third doped structure 130 and the fourth doped structure 131 are also embedded in the intrinsic semiconductor substrate 111. Specifically, a third doped region and a fourth doped region are provided in the intrinsic semiconductor substrate 111. The third doped region is of the second doping type, and the fourth doped region is of the first doping type. The third doped region is located on a side of the first doped region adjacent to the first surface 111b, and the fourth doped region is located on a side of the second doped region adjacent to the second surface 111c. The third doped region forms the third doped structure 130, and the fourth doped region forms the fourth doped structure 131.

As such, it is beneficial to increase the doped concentration on the surface of the intrinsic semiconductor substrate 111, thereby reducing the contact resistance between the electrode and the intrinsic semiconductor substrate 111, and further improving the efficiency of the solar cell 1.

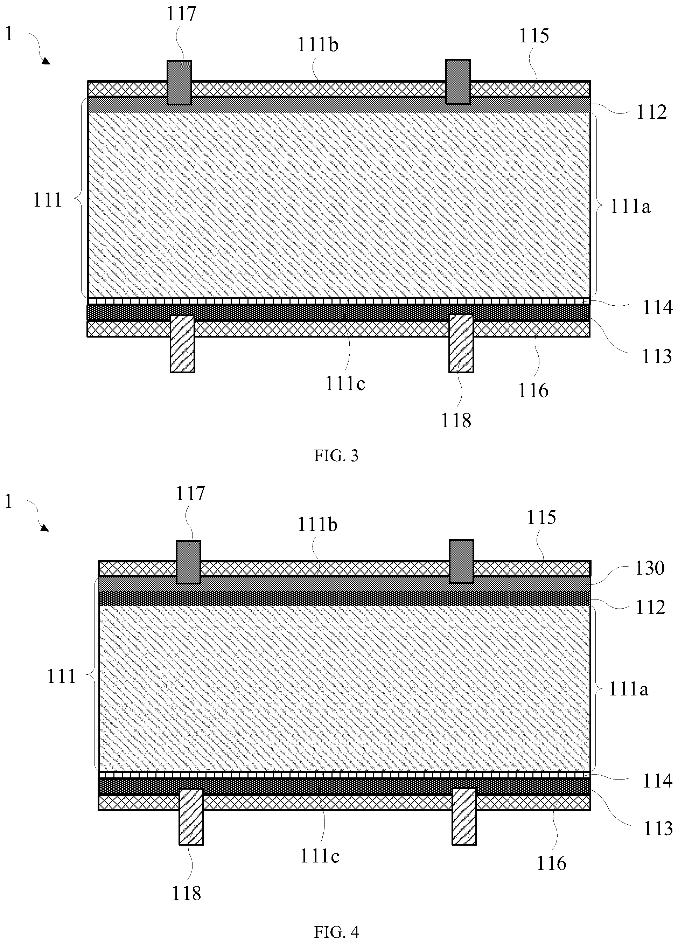

In an embodiment, as shown in FIGS. 3 and 4, the second doped structure 113 is provided on a side of the second surface 111c away from the first surface 111b. For example, the second doped structure 113 may be a polycrystalline silicon film containing a dopant. Further, the thickness of the polycrystalline silicon film may be in a range of 10 nm to 300 nm, and the doped concentration of the polycrystalline silicon film may be in a range of 1×10¹⁹ cm⁻³ to 5×10²⁰ cm⁻³.

In an embodiment, the solar cell 1 further includes a first tunneling layer 114. The first tunneling layer 114 is provided on the second surface 111c. The second doped structure 113 is provided on a side of the first tunneling layer 114 away from the first surface 111b. In this way, a passivation contact structure can be formed on the second surface 111c, so as to increase the open circuit voltage of the solar cell 1 and thus increase the conversion efficiency of the solar cell 1.

In an embodiment, the thickness of the first tunneling layer 114 is in a range of 0.5 nm to 5 nm.

In an embodiment, as shown in FIGS. 1 to 4, the solar cell 1 further includes a first passivation anti-reflection layer 115, a first electrode 117, a second passivation anti-reflection layer 116, and a second electrode 118. The first passivation anti-reflection layer 115 is provided on a side of the first doped structure 112 away from the intrinsic region 111a. The first electrode 117 is provided on a side of the first doped structure 112 away from the second doped structure 113, and extends through the first passivation anti-reflection layer 115 and is electrically connected to the first doped structure 112. The second passivation anti-reflection layer 116 is provided on a side of the second doped structure 113 away from the intrinsic region 111a. The second electrode 118 is provided on a side of the second doped structure 113 away from the first doped structure 112, and extends through the second passivation anti-reflection layer 116 and is electrically connected to the second doped structure 113. Specifically, the solar cell 1 shown in FIGS. 1 and 2 is a PERT cell, and the solar cell 1 shown in FIGS. 3 and 4 is a TOPCon cell.

In an embodiment, as shown in FIG. 4, the third doped structure 130 may be embedded in the intrinsic semiconductor substrate 111, which is beneficial for increasing the doped concentration on the surface of the intrinsic semiconductor substrate 111, thereby reducing the contact resistance between the first electrode 117 and the intrinsic semiconductor substrate 111, and increasing the efficiency of the solar cell 1.

In an embodiment, the first passivation anti-reflection layer may be made of a material including one or more elected from the group consisting of AlOₓ, SiNₓ, SiOₓ, SiNₓO_{y}, TiOₓ, MgF₂ and the like.

In an example, the first passivation anti-reflection layer is an AlOₓ layer, and the thickness of the AlOₓ layer is in a range of 1 nm to 20 nm.

In an example, the first passivation anti-reflection layer is a SiNₓ layer, and the thickness of the SiNₓ layer is in a range of 10 nm to 100 nm.

In an example, the first passivation anti-reflection layer is a SiOₓ layer, and the thickness of the SiOₓ layer is in a range of 10 nm to 150 nm.

In an example, the first passivation anti-reflection layer is a SiNₓO_{y} layer, and the thickness of the SiNₓO_{y} layer is in a range of 10 nm to 150 nm.

In an example, the first passivation anti-reflection layer is a TiOₓ layer, and the thickness of the TiOₓ layer is in a range of 10 nm to 150 nm.

In an example, the first passivation anti-reflection layer is an MgF₂ layer, and the thickness of the MgF₂ layer is in a range of 10 nm to 150 nm.

In an embodiment, the second passivation anti-reflection layer may be made of at least one material selected from the group consisting of AlOₓ, SiNₓ, SiOx, SiNₓO_{y}, TiOₓ, MgF₂, etc. The second passivation anti-reflection layer may be made of the same material as that of the first passivation anti-reflection layer. The thickness of the second passivation anti-reflection layer may be the same as that of the first passivation anti-reflection layer, and which are not repeatedly described herein in the embodiments of the present application.

In an embodiment, the first electrode 117 and the second electrode 118 may be made of at least one material selected from the group consisting of metals such as Ag, Al, Cu, Ni, and a mixture of any of the above metals and glass.

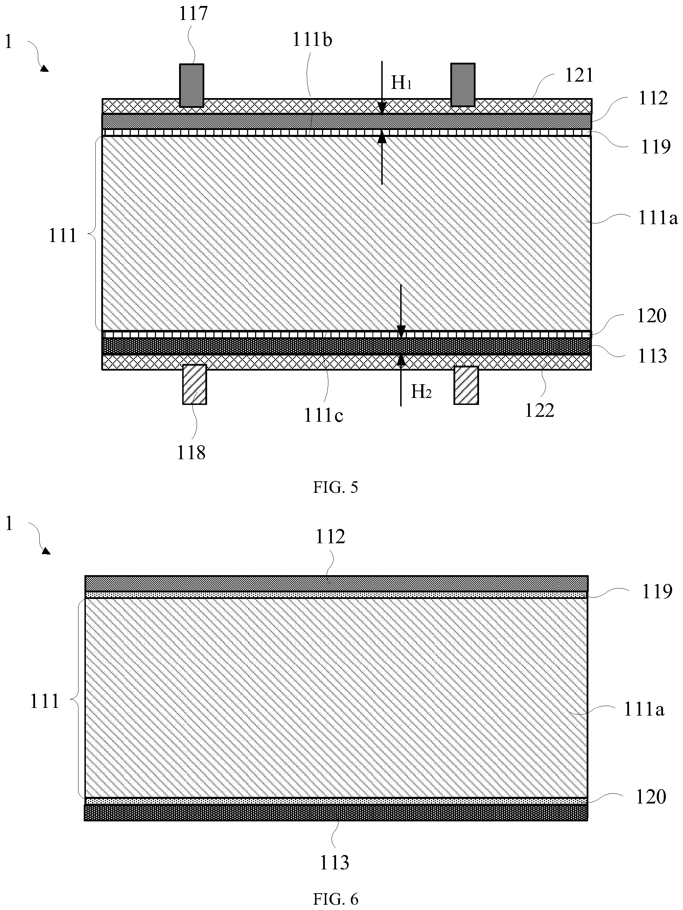

In an embodiment, as shown in FIGS. 5 and 6, the first doped structure 112 is provided on a side of the first surface 111b away from the second surface 111c. For example, the first doped structure 112 may be a microcrystalline or amorphous film containing a dopant. Further, the thickness of the first doped structure 112 may be in a range of 5 nm to 25 nm.

In an embodiment, the second doped structure 113 is provided on a side of the second surface 111c away from the first surface 111b. For example, the second doped structure 113 may be a microcrystalline or amorphous film containing a dopant. Further, the thickness of the second doped structure 113 may be in a range of 5 nm to 25 nm.

In an embodiment, the solar cell 1 further includes a first intrinsic semiconductor layer 119 and a second intrinsic semiconductor layer 120. The first intrinsic semiconductor layer 119 is provided on the first surface 111b, and the first doped structure 112 is provided on a side of the first intrinsic semiconductor layer 119 away from the second surface 111c. The second intrinsic semiconductor layer 120 is provided on the second surface 111c, and the second doped structure 113 is provided on a side of the second intrinsic semiconductor layer 120 away from the first surface 111b. For example, the first intrinsic semiconductor layer 119 and the second intrinsic semiconductor layer 120 are both intrinsic amorphous silicon thin films.

In an embodiment, the thickness of the first intrinsic semiconductor layer 119 and the thickness of the second intrinsic semiconductor layer 120 is in a range of 2 nm to 20 nm.

In an embodiment, as shown in FIG. 5, the solar cell 1 further includes a first transparent conductive layer 121, the first electrode 117, a second transparent conductive layer 122, and a second electrode 118. The first transparent conductive layer 121 is provided on a side of the first doped structure 112 away from the first intrinsic semiconductor layer 119. The first electrode 117 is provided on a side of the first transparent conductive layer 121 away from the first intrinsic semiconductor layer 119, and is electrically connected to the first transparent conductive layer 121. The second transparent conductive layer 122 is provided on a side of the second doped structure 113 away from the second intrinsic semiconductor layer 120. The second electrode 118 is provided on a side of the second transparent conductive layer 122 away from the second intrinsic semiconductor layer 120, and is electrically connected to the second transparent conductive layer 122. For example, the first transparent conductive layer 121 may be made of at least one material of indium tin oxide, tin oxide, and zinc oxide. The second transparent conductive layer 122 may be made of at least one material of indium tin oxide, tin oxide, and zinc oxide.

Here, it should be noted that the solar cell 1 shown in FIG. 5 is a SHJ cell, and the solar cell 1 shown in FIG. 6 is a tandem cell, and the figure only shows the bottom cell in the tandem cell, which is a SHJ cell. For example, the tandem cell may be a perovskite-silicon heterojunction tandem cell.

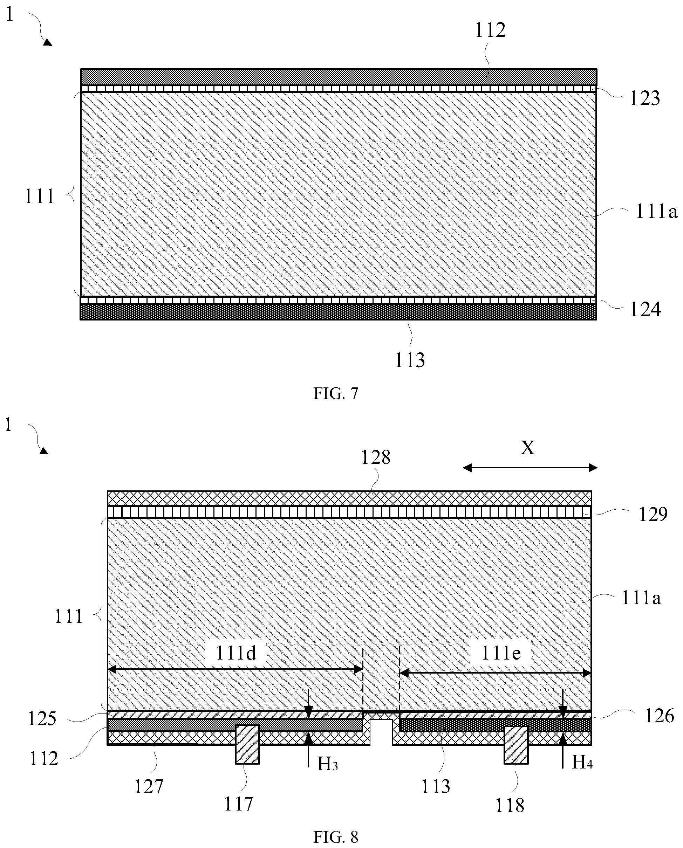

In an embodiment, as shown in FIG. 7, the solar cell 1 further includes a second tunneling layer 123 and a third tunneling layer 124. The second tunneling layer 123 is provided on the first surface 111b. The first doped structure 112 is provided on a side of the second tunneling layer 123 away from the second surface 111c. The third tunneling layer 124 is provided on the second surface 111c. The second doped structure 113 is provided on a side of the third tunneling layer 124 away from the first surface 111b.

Here, it should be noted that the solar cell 1 shown in FIG7 is a tandem cell, and the figure only shows the bottom cell in the tandem cell, which is a TOPCon cell. For example, the tandem cell may be a perovskite-TOPCon tandem cell.

In an example, the first doped structure 112 is a polysilicon film containing n-type dopants. Further, the doped concentration of the first doped structure 112 is in a range of 1×10¹⁹ cm ⁻³ to 5×10²⁰ cm⁻³, and the thickness of the first doped structure 112 is in a range of 10 nm to 300 nm.

In an example, the second doped structure 113 is a polysilicon film containing p-type dopants. Further, the doped concentration of the second doped structure 113 is in a range of 5×10¹⁸ cm⁻³ to 5×10²⁰ cm⁻³, and the thickness of the second doped structure 113 is in a range of 10 nm to 300 nm.

It should be noted that the solar cell 1 shown in FIGS. 5, 6 and 7 may also include the third doped structure 130 and/or the fourth doped structure 131. In an example, the third doped structure 130 and the first doped structure 112 may be provided in the same film layer, and the fourth doped structure 131 and the second doped structure 113 may be provided in the same film layer. In another example, the first doped structure 112, the second doped structure 113, the third doped structure 130 and the fourth doped structure 131 may also be individual film layer structures.

In a second aspect, as shown in FIG. 8, an embodiment of the present application provides another solar cell 1, which is a Back Contact (BC) cell. Specifically, the solar cell 1 includes an intrinsic semiconductor substrate 111, a first passivation layer 125, a second passivation layer 126, a first doped structure 112, and a second doped structure 113. The intrinsic semiconductor substrate 111 has a first surface 111b and a second surface 111c that are arranged opposite to each other. The intrinsic semiconductor substrate 111 is provided with a first conductive region 111d and a second conductive region 111e that are arranged in a first direction X. The first direction X is perpendicular to the thickness direction of the intrinsic semiconductor substrate 111. The first passivation layer 125 is provided on the first surface 111b and is located in the first conductive region 111d. The second passivation layer 126 is provided on the first surface 111b and is located in the second conductive region 111e. The first doped structure 112 has a first doping type and is provided on a side of the first passivation layer 125 away from the intrinsic semiconductor substrate 111. The second doped structure 113 has a second doping type and is provided on a side of the second passivation layer 126 away from the intrinsic semiconductor substrate 111.

The first doping type is opposite to the second doping type, and the first doped structure 112, the intrinsic semiconductor substrate 111 and the second doped structure 113 form a p-i-n structure.

In the solar cell 1 according to the embodiment of the present application, by disposing the intrinsic region 111a, the first doped structure 112 and the second doped structure 113 on the intrinsic semiconductor substrate 111, the first doped structure 112, the intrinsic region 111a and the second doped structure 113 form the p-i-n structure. As such, compared with the conventional technology of using a p-type or n-type semiconductor substrate 111 to manufacture the solar cell 1, the substrate of the solar cell 1 according to the embodiment of the present application adopts the intrinsic semiconductor substrate 111 including the intrinsic region 111a, therefore, during the process of manufacturing a blank (such as a silicon rod) of the intrinsic semiconductor substrate 111, it is not necessary to dope a p-type or n-type dopant, which, on the one hand, is beneficial to reduce the complexity of the manufacturing process of the solar cell 1 and is more beneficial to the growth of silicon crystals, on the other hand, can reduce the dislocation density in the silicon crystals, increase the crystal pulling speed, and reduce the defect density. Furthermore, after the silicon rod is cut into wafers, there is no resistivity difference in the radial and longitudinal directions of the intrinsic silicon wafer, which, on the one hand, is beneficial to improve the electrical consistency of the silicon wafer, thereby improving the conversion efficiency of the solar cell 1; on the other hand, is beneficial to improve the utilization rate of the silicon rod, thereby reducing the manufacturing cost of the solar cell 1.

Here, it should also be noted that the solar cell 1 according to the embodiment of the present application has a p-i junction and an i-n junction provided on both sides of the intrinsic semiconductor substrate 111, respectively. With such a structure, the carrier can have a better separation effect, thereby improving the photoelectric conversion efficiency of the solar cell 1. Specifically, compared with the substrate of the conventional solar cell 1, the intrinsic semiconductor substrate 111 in the embodiment of the present application includes the intrinsic region 111a, so the doped concentration of the intrinsic semiconductor substrate 111 is much lower than the doped concentration of the conventional substrate. Moreover, because the lower the doped concentration of the substrate, the deeper the built-in electric field of the solar cell 1 extends into the substrate, therefore, the built-in electric field of the solar cell 1 in the embodiment of the present application extends deeper into the substrate, and has a larger influence range, thereby improving the separation effect of the carriers.

It should be understood that a plurality of first conductive regions 111d and a plurality of second conductive regions 111e may be provided on the intrinsic semiconductor substrate 111. The plurality of first conductive regions 111d and the plurality of second conductive regions 111e are alternately arranged in the first direction X. Each first conductive region 111d is provided with the first passivation layer 125 and the first doped structure 112, and each second conductive region 111e is provided with the second passivation layer 126 and the second doped structure 113. A partition trench is provided between adjacent first doped structure 112 and second doped structure 113.

In an embodiment, the resistivity of the intrinsic semiconductor substrate 111 is greater than 100 Ω·cm. In other words, the content of the dopant in the intrinsic region 111a is particularly small. As such, it is beneficial to increase the depth of the built-in electric field extending into the intrinsic semiconductor substrate 111, thereby helping to improve the separation effect of the carriers.

In an embodiment, the doped concentration of the p-type dopant in the intrinsic region 111a is less than or equal to 1.3×10¹⁴ cm⁻³, and the doped concentration of the n-type dopant in the intrinsic region 111a is less than or equal to 4.4×10¹³ cm⁻³. In this way, the content of the dopant in the intrinsic region 111a is particularly small. As such, it is beneficial to increase the depth of the built-in electric field extending into the intrinsic semiconductor substrate 111, thereby helping to improve the separation effect of carriers.

In an embodiment, the thickness of the intrinsic semiconductor substrate 111 is in a range of 50 µm to 300 µm. For example, the thickness of the intrinsic semiconductor substrate 111 may be 50 µm, 60 µm, 65 µm, 80 µm, 100 µm, 130 µm, 160 µm, 190 µm, 230 µm, 270 µm, 290 µm, 300 µm, or between any two of the above values. By configuring the thickness of the intrinsic semiconductor substrate 111 to be within the above range, it is beneficial to reduce the thickness of the solar cell 1 on the one hand, and to form a stable p-i-n structure on the other hand.

In an embodiment, the doped concentration of the first doped structure 112 is between 3×10¹⁸ cm⁻³ and 5×10²⁰ cm⁻³. For example, the doped concentration of the first doped structure 112 may be 3×10¹⁸ cm⁻³, 5×10¹⁸ cm⁻³, 1×10¹⁹ cm⁻³, 5×10²⁰ cm⁻³, or between any two of the above values. By configuring the doped concentration of the first doped structure 112 to be within the above range, on the one hand, it is beneficial to reduce the manufacturing cost, and on the other hand, the first doped structure 112 can have a better conductivity.

In an embodiment, the doped concentration of the second doped structure 113 is in a range of 3×10¹⁸ cm⁻³ to 5×10²⁰ cm⁻³. For example, the doped concentration of the second doped structure 113 may be 3×10¹⁸ cm⁻³, 5×10¹⁸ cm⁻³, 1×10¹⁹ cm⁻³, 5×10²⁰ cm⁻³, or between any two of the above values. By configuring the doped concentration of the second doped structure 113 to be within the above range, on the one hand, it is beneficial to reduce the manufacturing cost, and on the other hand, the second doped structure 113 can have a better conductivity.

In an embodiment, a third dimension H₃ is defined between a side of the first doped structure 112 adjacent to the first surface 111b and a side of the first doped structure 112 away from the first surface 111b, where the third dimension H₃ is in a range of 5 nm to 5000 nm. For example, the third dimension H₃ may be 5 nm, 10 nm, 100 nm, 1500 nm, 2500 nm, 3000 nm, 4000 nm, 5000 nm, or between any two of the above values. By configuring the third dimension H₃ to be within the above range, it is beneficial to reduce manufacturing costs on the one hand, and to form a stable p-i-n structure on the other hand.

In an embodiment, a fourth dimension H₄ is defined between a side of the second doped structure 113 adjacent to the first surface 111b and a side of the second doped structure 113 away from the first surface 111b, where the fourth dimension H₄ is in a range of 5 nm to 5000 nm. For example, the fourth dimension H₄ may be 5 nm, 10 nm, 100 nm, 1500 nm, 2500 nm, 3000 nm, 4000 nm, 5000 nm, or between any two of the above values. By configuring the fourth dimension H₄ to be within the above range, it is beneficial to reduce manufacturing costs on the one hand, and to form a stable p-i-n structure on the other hand.

In an embodiment, the solar cell 1 further includes a third doped structure 130. The third doped structure 130 has a second doping type and is provided on a side of the first doped structure 112 away from the intrinsic region 111a. The third doped structure 130 and the first doped structure 112 form a p-n junction. In an example, the third doped structure 130 and the first doped structure 112 can be provided in the same film layer structure. In this way, it is beneficial to increase the doped concentration of the contact interface between the first electrode 117 and the intrinsic semiconductor substrate 111, thereby reducing the contact resistance of the contact interface between the first electrode 117 and the intrinsic semiconductor substrate 111, and thus improving the efficiency of the solar cell 1. It is understandable that the first doped structure 112 and the third doped structure 130 can also be individual film layer structures.

In an embodiment, the solar cell 1 further includes a fourth doped structure 131. The fourth doped structure 131 has a first doping type and is provided on a side of the second doped structure 113 away from the intrinsic semiconductor substrate 111. The fourth doped structure 131 and the second doped structure 113 form a p-n junction. In an example, the fourth doped structure 131 and the second doped structure 113 can be provided in the same film layer structure, which is beneficial to increase the doped concentration of the contact interface between the second electrode 118 and the intrinsic semiconductor substrate 111, thereby reducing the contact resistance of the contact interface between the second electrode 118 and the intrinsic semiconductor substrate 111, and thus improving the efficiency of the solar cell 1. It is understandable that the second doped structure 113 and the fourth doped structure 131 may also be individual film layer structures.

In an embodiment, the first passivation layer 125 and the second passivation layer 126 are configured as tunneling dielectric layers. For example, the first passivation layer 125 and the second passivation layer 126 may be made of SiOₓ. The thickness of the first passivation layer 125 and the thickness of the second passivation layer 126 may be in a range of 0.5 nm to 5 nm.

Furthermore, the first doped structure 112 and the second doped structure 113 may be made of a material including polysilicon. The thickness of the first doped structure 112 and the thickness of the second doped structure 113 may be in a range of 10 nm to 300 nm.

In an embodiment, the first passivation layer 125 and the second passivation layer 126 may be made of a material including an intrinsic semiconductor material. For example, the first passivation layer 125 and the second passivation layer 126 may be made of intrinsic microcrystalline silicon or intrinsic amorphous silicon. The thickness of the first passivation layer 125 and the thickness of the second passivation layer 126 may be in a range of 2 nm to 20 nm. Further, the first doped structure 112 and the second doped structure 113 may be made of a material including microcrystalline silicon or amorphous silicon. The thickness of the first doped structure 112 and the thickness of the second doped structure 113 may be in a range of 5 nm to 25 nm.

In an embodiment, the solar cell 1 further includes a first anti-reflection layer 127, the first electrode 117, the second electrode 118, a third passivation layer 129, and a second anti-reflection layer 128. The first anti-reflection layer 127 is provided on a side of the first doped structure 112 away from the intrinsic semiconductor substrate 111, and on a side of the second doped structure 113 away from the intrinsic semiconductor substrate 111. The first electrode 117 is provided on a side of the first doped structure 112 away from the intrinsic semiconductor substrate 111, and extends through the first anti-reflection layer 127 and is electrically connected to the first doped structure 112. The second electrode 118 is provided on a side of the second doped structure 113 away from the intrinsic semiconductor substrate 111, and extends through the first anti-reflection layer 127 and is electrically connected to the second doped structure 113. The third passivation layer 129 is provided on the second surface 111c. The second anti-reflection layer 128 is provided on a side of the third passivation layer 129 away from the intrinsic semiconductor substrate 111.

In an embodiment, the third passivation layer 129 may be made of a material including SiNₓ, AlOₓ, amorphous silicon, etc. When the third passivation layer 129 is made of SiNₓ, the thickness of the third passivation layer 129 may be in a range of 50 nm to 120 nm. When the third passivation layer 129 is made of AlOₓ, the thickness of the third passivation layer 129 may be in a range of 1 nm to 20 nm. When the third passivation layer 129 is made of amorphous silicon, the thickness of the first passivation layer 125 and the thickness of the second passivation layer 126 may be in a range of 2 nm to 20 nm.

In an embodiment, the first anti-reflection layer 127 and the second anti-reflection layer 128 may be made of at least one material selected from the group consisting of SiNₓ, SiOₓ, SiNₓO_{y}, AlOₓ, ITO, SnO₂, MgF₂, TiOₓ and ZnO.

It should be noted that the inventors have conducted electrical performance experiments on a conventional BC cell adopting silicon substrates and silicon wafers and the BC cells according to the embodiments of the present application, and the results are shown in the following table:

### electrical performance comparison

| | Open circuit voltage Voc[mV] | Short circuit current [mA] | Fill factor FF [%] | Efficiency Eff [%] |
|---|---|---|---|---|
| Conventional BC cell | BSL | BSL | BSL | BSL |
| BC cell according to the embodiments of the present application | BSL+1.4 | BSL-10 | BSL+0.03 | BSL+0.04 |

It can be seen from the above table that, compared with the conventional BC cell, the embodiments of the present application improve the fill factor and the open circuit voltage, reduce the short circuit current, and in particular, improve the efficiency by 0.04%. It can be seen that the embodiments of the present application have obvious efficiency gains.

It should be noted that the above experimental results are limited by the current experimental level. The inventors believe that there is still room for further improvement of solar cells adopting intrinsic semiconductor substrates.

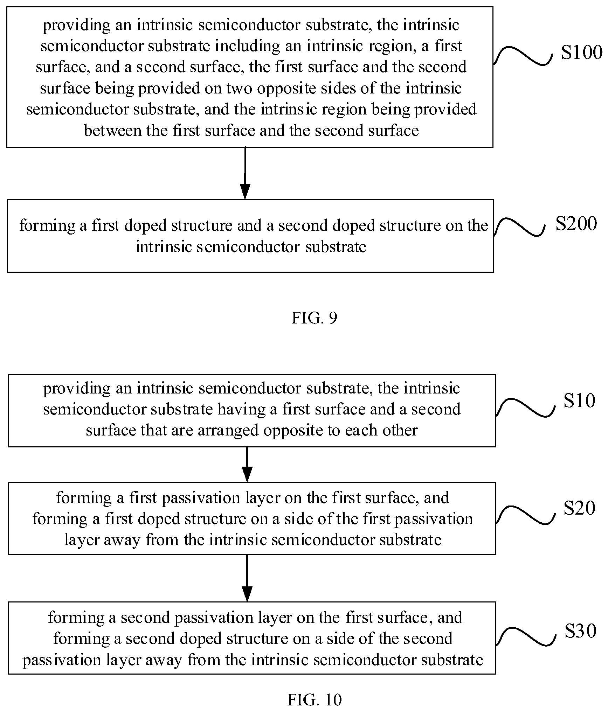

In a third aspect, as shown in FIG. 9, an embodiment of the present application provides a manufacturing method of a solar cell. The manufacturing method is used to manufacture the solar cell in the first aspect, and specifically, the manufacturing method includes steps as follows.

At step S100, an intrinsic semiconductor substrate is provided. The intrinsic semiconductor substrate includes an intrinsic region, a first surface, and a second surface. The first surface and the second surface are provided on two opposite sides of the intrinsic semiconductor substrate, and the intrinsic region is provided between the first surface and the second surface.

At step S200, a first doped structure and a second doped structure are formed on the intrinsic semiconductor substrate. The first doped structure has a first doping type and is provided on a side of the intrinsic region adjacent to the first surface. The second doped structure has a second doping type and is provided on a side of the intrinsic region adjacent to the second surface. The first doping type is opposite to the second doping type. The first doped structure, the intrinsic region, and the second doped structure form a p-i-n structure.

In an embodiment, taking the solar cell shown in FIG. 1 as an example, step S200 specifically includes steps as follows.

At step S210, the intrinsic semiconductor substrate is placed in a high-temperature diffusion furnace, a p-type dopant (such as boron) is diffused into the intrinsic semiconductor substrate, and then the oxide layer (borosilicate glass) and the diffusion layer on the second surface of the intrinsic semiconductor substrate are removed to form the first doped structure. For example, the diffusion depth may be 0.8 µm, and the doped concentration may be 5×10¹⁸ cm⁻³. It can be understood that prior to step S210, pyramid textures are formed on the first surface and the second surface of the intrinsic semiconductor substrate.

At step S220, the intrinsic semiconductor substrate is cleaned.

At step S230, the intrinsic semiconductor substrate is placed in the high-temperature diffusion furnace, an n-type dopant (such as phosphorus) is diffused into the intrinsic semiconductor substrate, and then oxide layers (such as borosilicate glass, phosphorus silicon glass) on the first surface and the second surface are removed to form the second doped structure, and then the intrinsic semiconductor substrate is cleaned. For example, the diffusion depth may be 0.8 µm, and the doped concentration may be 1×10²⁰ cm⁻³.

At step S240, a first passivation anti-reflection layer is formed on the first doped structure, and a second passivation anti-reflection layer is formed on the second doped structure.

At step S250, a first electrode and a second electrode are formed. The first electrode extends through the first passivation anti-reflection layer and is electrically connected to the first doped structure, and the second electrode extends through the second passivation anti-reflection layer and is electrically connected to the second doped structure. For example, a silver-aluminum paste may be printed on the first passivation anti-reflection layer, and a silver paste may be printed on the second passivation anti-reflection layer by a screen printing process, and then the silver paste is sintered to obtain the first electrode and the second electrode.

It should be noted that if the solar cell shown in FIG. 2 is to be manufactured, in step S210, a third doped structure is formed by diffusion on the side of the intrinsic region adjacent to the first surface. In step S230, a fourth doped structure is formed by diffusion on the side of the intrinsic region adjacent to the second surface.

In an embodiment, taking the solar cell shown in FIG. 3 as an example, step S200 specifically includes steps as follows.

At step S210, the intrinsic semiconductor substrate is placed in the high-temperature diffusion furnace, a p-type dopant (such as boron) is diffused into the intrinsic semiconductor substrate, and then the oxide layer (borosilicate glass) and the diffusion layer on the second surface of the intrinsic semiconductor substrate are removed to form the first doped structure. For example, the diffusion depth may be 0.8 µm, and the doped concentration may be 5×10¹⁸ cm⁻³. It can be understood that before step S210, pyramid textures are formed on the first surface and the second surface of the intrinsic semiconductor substrate.

At step S220, the intrinsic semiconductor substrate is cleaned.

At step S230, a first tunneling layer is formed on the second surface of the intrinsic semiconductor substrate.

At step S240, the second doped structure is formed on the first tunneling layer. For example, a polysilicon film doped with an n-type dopant is first deposited on the first tunneling layer, and then the polysilicon film is annealed to activate the dopant, so that the second doped structure is formed.

At step S250, a first passivation anti-reflection layer is formed on the first doped structure, and a second passivation anti-reflection layer is formed on the second doped structure.

At step S260, a first electrode and a second electrode are formed. The first electrode extends through the first passivation anti-reflection layer and is electrically connected to the first doped structure, and the second electrode extends through the second passivation anti-reflection layer and is electrically connected to the second doped structure. For example, a silver-aluminum paste may be printed on the first passivation anti-reflection layer, and a silver paste may be printed on the second passivation anti-reflection layer by a screen printing process, and then a sintering is performed to obtain the first electrode and the second electrode.

In an embodiment, taking the solar cell shown in FIG. 5 as an example, step S200 specifically includes steps as follows.

At step S210, a first intrinsic semiconductor layer is formed on the first surface of the intrinsic semiconductor substrate.

At step S220, a second intrinsic semiconductor layer is formed on the second surface of the intrinsic semiconductor substrate.

At step S230, a first doped structure is formed on the first intrinsic semiconductor layer.

At step S240, a second doped structure is formed on the second intrinsic semiconductor layer.

At step S250, a first transparent conductive layer is formed on the first doped structure.

At step S260, a second transparent conductive layer is formed on the second doped structure.

At step S270, a first electrode is formed on the first transparent conductive layer, and a second electrode is formed on the second transparent conductive layer. For example, an electrode paste may be printed by screen printing, and then sintered to obtain the first electrode and the second electrode.

It should be noted that if the solar cell shown in FIG. 8 is to be manufactured, it is necessary to, prior to forming the first doped structure and the second doped structure, form a second tunneling layer on the first surface, form a third tunneling layer on the second surface, and then form the first doped structure on the second tunneling layer, and form the second doped structure on the third tunneling layer.

In a fourth aspect, as shown in FIG. 10, an embodiment of the present application provides another manufacturing method of a solar cell. The manufacturing method is used to manufacture the solar cell in the second aspect, and specifically, the manufacturing method includes steps as follows

At step S10, an intrinsic semiconductor substrate is provided. The intrinsic semiconductor substrate has a first surface and a second surface that are arranged opposite to each other. A first conductive region and a second conductive region arranged in a first direction are provided on the intrinsic semiconductor substrate. The first direction is perpendicular to a thickness direction of the intrinsic semiconductor substrate.

At step S20, a first passivation layer is formed on the first surface, and a first doped structure is formed on a side of the first passivation layer away from the intrinsic semiconductor substrate. The first passivation layer is located in the first conductive region, and the first doped structure has a first doping type.

At step S30, a second passivation layer is formed on the first surface, and a second doped structure is formed on a side of the second passivation layer away from the intrinsic semiconductor substrate. The second passivation layer is located in the second conductive region, the second doped structure has a second doping type. The first doping type is opposite to the second doping type. The first doped structure, the intrinsic semiconductor substrate and the second doped structure form a p-i-n structure.

In an embodiment, the manufacturing method further includes steps as follows.

At step S40, a first anti-reflection layer is formed on the first surface, the first anti-reflection layer covering the first doped structure and the second doped structure, and a third passivation layer and a second anti-reflection layer are formed on the second surface. The third passivation layer is located between the intrinsic semiconductor substrate and the second anti-reflection layer.

At step S50, a first electrode and a second electrode are formed. The first electrode is electrically connected to the first doped structure, and the second electrode is electrically connected to the second doped structure.

In a fifth aspect, an embodiment of the present application provides a photovoltaic module, including the solar cell according to any of the embodiments of the first and second aspects.

For example, the photovoltaic module includes a plurality of solar cells. The plurality of solar cells can be connected in series by welding ribbons, so that the electric energy generated by the individual solar cells can be collected for subsequent transmission. Certainly, the solar cells can be arranged at intervals or stacked in a shingled form.

Furthermore, the photovoltaic module further includes a packaging layer and a cover plate (not shown). The packaging layer is configured to cover the surface of the cell string. The cover plate is configured to cover the surface of the packaging layer away from the cell string. The solar cells are electrically connected in the form of a whole piece or multiple pieces to form a plurality of cell strings. The plurality of cell strings are electrically connected in series and/or in parallel. Specifically, in some embodiments, the plurality of cell strings can be electrically connected by a conductive tape. The packaging layer covers the surface of the solar cell. For example, the packaging layer can be an organic packaging film such as an ethylene-vinyl acetate copolymer film, a polyethylene-octene co-elastic film, or a polyethylene terephthalate film. The cover plate can be a cover plate with a light-transmitting property such as a glass cover plate or a plastic cover plate.

In the photovoltaic module according to the embodiment of the present application, by disposing the intrinsic region on the intrinsic semiconductor substrate and disposing the first doped structure and the second doped structure on opposite sides of the intrinsic region, the first doped structure, the intrinsic region and the second doped structure form the p-i-n structure. Thus, compared with conventional technology of using a p-type or n-type semiconductor substrate to manufacture the solar cell, the substrate of the solar cell according to the embodiment of the present application adopts the intrinsic semiconductor substrate including the intrinsic region, therefore, in the process of manufacturing a blank (such as a silicon rod) of the intrinsic semiconductor substrate, it is not necessary to dope a p-type or n-type dopant, which is beneficial to reduce the complexity of the manufacturing process of the solar cell on the one hand, and is more beneficial to the growth of silicon crystals, can reduce the dislocation density in the silicon crystals, increase the crystal pulling speed, and reduce the defect density on the other hand. Furthermore, after the silicon rod is cut into wafers, there is no resistivity difference in the radial and longitudinal directions of the intrinsic silicon wafer, which, on the one hand, is beneficial to improve the electrical consistency of the silicon wafer, thereby improving the conversion efficiency of the solar cell; on the other hand, is beneficial to improve the utilization rate of the silicon rod, thereby reducing the manufacturing cost of the solar cell.

In a sixth aspect, an embodiment of the present application provides a photovoltaic system, including the photovoltaic module in the fifth aspect.

Specifically, the photovoltaic system can be applied in photovoltaic power stations, such as ground power stations, rooftop power stations, water power stations, etc., and can also be applied in equipment or devices that use solar energy to generate electricity, such as user solar power supplies, solar street lights, solar vehicles, solar buildings, etc. Certainly, it can be understood that the application scenarios of the photovoltaic system are not limited hereto. That is, the photovoltaic system can be applied in all fields that require solar energy to generate electricity. Taking the photovoltaic power generation system network as an example, the photovoltaic system may include a photovoltaic array, a junction box and an inverter. The photovoltaic array may be a combination of multiple arrays of photovoltaic modules. For example, multiple photovoltaic modules can form multiple photovoltaic arrays. The photovoltaic arrays are connected to the junction box. The junction box can converge the current generated by the photovoltaic arrays. The converged current flows through the inverter and is converted into the alternating current required by the mains power grid, and then is connected to the mains network to realize solar power supply.

In the photovoltaic system according to the embodiment of the present application, by disposing the intrinsic region on the intrinsic semiconductor substrate, and disposing the first doped structure and the second doped structure on opposite sides of the intrinsic region, the first doped structure, the intrinsic region and the second doped structure form the p-i-n structure. As such, compared with the conventional technology of using a p-type or n-type semiconductor substrate to manufacture a solar cell, the substrate of the solar cell according to the embodiment of the present application adopts the intrinsic semiconductor substrate including the intrinsic region, therefore, in the process of manufacturing a blank (such as a silicon rod) of the intrinsic semiconductor substrate, it is not necessary to dope a p-type or n-type dopant, which is beneficial to reduce the complexity of the manufacturing process of the solar cell on the one hand, and is more beneficial to the growth of silicon crystals, can reduce the dislocation density in the silicon crystals, increase the crystal pulling speed, and reduce the defect density on the other hand. Furthermore, after the silicon rod is cut into wafers, there is no resistivity difference in the radial and longitudinal directions of the intrinsic silicon wafer, which, on the one hand, is beneficial to improve the electrical consistency of the silicon wafer, thereby improving the conversion efficiency of the solar cell; on the other hand, is beneficial to improve the utilization rate of the silicon rod, thereby reducing the manufacturing cost of the solar cell.

The technical features of the above-mentioned embodiments can be combined arbitrarily. In order to make the description concise, not all possible combinations of the technical features are described in the embodiments. However, as long as there is no contradiction in the combination of these technical features, these combinations should be considered to fall within the scope of the present application.

The above-described embodiments only illustrate several implementations of the present application, and the descriptions are relatively specific and detailed, but they should not be construed as limiting the scope of the present application. It should be understood by those of ordinary skill in the art that various modifications and improvements can be made without departing from the concept of the present application, and all fall within the protection scope of the present application. Therefore, the patent protection of the present application shall be defined by the appended claims.

## Claims

1. A solar cell, comprising:
an intrinsic semiconductor substrate including an intrinsic region, a first surface, and a second surface, wherein the first surface and the second surface are provided on opposite sides of the intrinsic semiconductor substrate, and the intrinsic region is provided between the first surface and the second surface;
a first doped structure having a first doping type, the first doped structure being provided on a side of the intrinsic region adjacent to the first surface; and
a second doped structure having a second doping type, the second doped structure being provided on a side of the intrinsic region adjacent to the second surface;
wherein the first doping type is opposite to the second doping type, and the first doped structure, the intrinsic region, and the second doped structure form a p-i-n structure.

2. The solar cell according to claim 1, wherein a resistivity of the intrinsic region is greater than 100 Ω·cm.

3. The solar cell according to claim 1, wherein a doped concentration of a p-type dopant in the intrinsic region is less than or equal to 1.3×10¹⁴ cm⁻³, and a doped concentration of a n-type dopant in the intrinsic region is less than or equal to 4.4×10¹³ cm⁻³.

4. The solar cell according to claim 1, wherein a thickness of the intrinsic semiconductor substrate is in a range of 50 µm to 300 µm.

5. The solar cell according to claim 1, wherein a doped concentration of the first doped structure is in a range of 3×10¹⁸ cm⁻³ to 5×10²⁰ cm⁻³.

6. The solar cell according to claim 1, wherein a doped concentration of the second doped structure is in a range of 3×10¹⁸ cm⁻³ to 5×10²⁰ cm⁻³.

7. The solar cell according to claim 1, wherein a first dimension is defined between a side of the first doped structure adjacent to the first surface and a side of the first doped structure away from the first surface, and the first dimension is in a range of 5 nm to 5000 nm.

8. The solar cell according to claim 1, wherein a second dimension is defined between a side of the second doped structure adjacent to the first surface and a side of the second doped structure away from the first surface, and the second dimension is in a range of 5 nm to 5000 nm.

9. The solar cell according to claim 1, further comprising a third doped structure, wherein the third doped structure has the second doping type and is provided on a side of the first doped structure away from the intrinsic region, and the third doped structure and the first doped structure form a p-n junction.

10. The solar cell according to claim 9, further comprising a fourth doped structure, wherein the fourth doped structure has the first doping type and is provided on a side of the second doped structure away from the intrinsic region, and the fourth doped structure and the second doped structure form a p-n junction.

11. The solar cell according to any one of claims 1 to 10, wherein the first doped structure is embedded in the intrinsic semiconductor substrate and is located between the intrinsic region and the first surface.

12. The solar cell according to claim 11, wherein the second doped structure is embedded in the intrinsic semiconductor substrate and is located between the intrinsic region and the second surface.

13. The solar cell according to claim 11, wherein the second doped structure is provided on a side of the second surface away from the first surface.

14. The solar cell according to claim 13, further comprising a first tunneling layer provided on the second surface, wherein the second doped structure is provided on a side of the first tunneling layer away from the first surface.

15. The solar cell according to any one of claims 1 to 14, further comprising:
a first passivation anti-reflection layer provided on a side of the first doped structure away from the intrinsic region;
a first electrode provided on a side of the first doped structure away from the second doped structure, the first electrode extending through the first passivation anti-reflection layer and being electrically connected to the first doped structure;
a second passivation anti-reflection layer provided on a side of the second doped structure away from the intrinsic region; and
a second electrode provided on a side of the second doped structure away from the first doped structure, the second electrode extending through the second passivation anti-reflection layer, and being electrically connected to the second doped structure.

16. The solar cell according to any one of claims 1 to 10, wherein the first doped structure is provided on a side of the first surface away from the second surface.

17. The solar cell according to claim 16, wherein the second doped structure is provided on a side of the second surface away from the first surface.

18. The solar cell according to claim 17, further comprising:
a first intrinsic semiconductor layer provided on the first surface, wherein the first doped structure is provided on a side of the first intrinsic semiconductor layer away from the second surface; and
a second intrinsic semiconductor layer provided on the second surface, wherein the second doped structure is provided on a side of the second intrinsic semiconductor layer away from the first surface.

19. The solar cell according to claim 18, further comprising:
a first transparent conductive layer provided on a side of the first doped structure away from the first intrinsic semiconductor layer;
a first electrode provided on a side of the first transparent conductive layer away from the first intrinsic semiconductor layer and being electrically connected to the first transparent conductive layer;
a second transparent conductive layer provided on a side of the second doped structure away from the second intrinsic semiconductor layer; and
a second electrode provided on a side of the second transparent conductive layer away from the second intrinsic semiconductor layer and being electrically connected to the second transparent conductive layer.

20. The solar cell according to claim 17, further comprising:
a second tunneling layer provided on the first surface, wherein the first doped structure is provided on a side of the second tunneling layer away from the second surface; and
a third tunneling layer provided on the second surface, wherein the second doped structure is provided on a side of the third tunneling layer away from the first surface.

21. A solar cell, comprising:
an intrinsic semiconductor substrate having a first surface and a second surface that are arranged opposite to each other, wherein a first conductive region and a second conductive region that are arranged in a first direction are provided on the intrinsic semiconductor substrate, and the first direction is perpendicular to a thickness direction of the intrinsic semiconductor substrate;
a first passivation layer provided on the first surface and located in the first conductive region;
a second passivation layer provided on the first surface and located in the second conductive region;
a first doped structure having a first doping type and provided on a side of the first passivation layer away from the intrinsic semiconductor substrate; and
a second doped structure having a second doping type and provided on a side of the second passivation layer away from the intrinsic semiconductor substrate;
wherein the first doping type is opposite to the second doping type, and the first doped structure, the intrinsic semiconductor substrate, and the second doped structure form a p-i-n structure.

22. The solar cell according to claim 21, wherein a resistivity of the intrinsic semiconductor substrate is greater than 100 Ω·cm.

23. The solar cell according to claim 21, wherein a doped concentration of a p-type dopant in the intrinsic semiconductor substrate is less than or equal to 1.3×10¹⁴ cm⁻³, and a doped concentration of a n-type dopant in the intrinsic semiconductor substrate is less than or equal to 4.4×10¹³ cm⁻³.

24. The solar cell according to claim 21, wherein a thickness of the intrinsic semiconductor substrate is in a range of 50 µm to 300 µm.

25. The solar cell according to claim 21, wherein a doped concentration of the first doped structure is in a range of 3×10¹⁸ cm⁻³ to 5×10²⁰ cm⁻³.

26. The solar cell according to claim 21, wherein a doped concentration of the second doped structure is in a range of 3×10¹⁸ cm⁻³ to 5×10²⁰ cm⁻³.

27. The solar cell according to claim 21, wherein a third dimension is defined between a side of the first doped structure adjacent to the first surface and a side of the first doped structure away from the first surface, and the third dimension is in a range of 5 nm to 5000 nm.

28. The solar cell according to claim 21, wherein a fourth dimension is defined between a side of the second doped structure adjacent to the first surface and a side of the second doped structure away from the first surface, and the fourth dimension is in a range of 5 nm to 5000 nm.

29. The solar cell according to claim 21, further comprising a third doped structure; wherein the third doped structure has the second doping type and is provided on a side of the first doped structure away from the intrinsic semiconductor substrate, and the third doped structure and the first doped structure form a p-n junction.

30. The solar cell according to claim 21, further comprising a fourth doped structure; wherein the fourth doped structure has the first doping type and is provided on a side of the second doped structure away from the intrinsic semiconductor substrate, and the fourth doped structure and the second doped structure form a p-n junction.

31. The solar cell according to claim 21, wherein the first passivation layer and the second passivation layer are configured as tunneling dielectric layers.

32. The solar cell according to claim 21, wherein the first doped structure and the second doped structure are made of a material including polysilicon.

33. The solar cell according to claim 21, wherein the first passivation layer and the second passivation layer are made of a material including an intrinsic semiconductor material.

34. The solar cell according to claim 21, wherein the first doped structure and the second doped structure are made of a material including microcrystalline silicon or amorphous silicon.

35. The solar cell according to claim 21, further comprising:
a first anti-reflection layer provided on a side of the first doped structure away from the intrinsic semiconductor substrate, and on a side of the second doped structure away from the intrinsic semiconductor substrate;
a first electrode provided on a side of the first doped structure away from the intrinsic semiconductor substrate, the first electrode extending through the first anti-reflection layer and being electrically connected to the first doped structure;
a second electrode provided on a side of the second doped structure away from the intrinsic semiconductor substrate, the second electrode extending through the first anti-reflection layer and being electrically connected to the second doped structure;
a third passivation layer provided on the second surface; and
a second anti-reflection layer provided on a side of the third passivation layer away from the intrinsic semiconductor substrate.

36. A manufacturing method of a solar cell, comprising:
providing an intrinsic semiconductor substrate, the intrinsic semiconductor substrate including an intrinsic region, a first surface, and a second surface, the first surface and the second surface being provided on opposite sides of the intrinsic semiconductor substrate, and the intrinsic region being provided between the first surface and the second surface; and
forming a first doped structure and a second doped structure on the intrinsic semiconductor substrate;
wherein the first doped structure has a first doping type and is provided on a side of the intrinsic region adjacent to the first surface; the second doped structure has a second doping type and is provided on a side of the intrinsic region adjacent to the second surface; the first doping type is opposite to the second doping type; and the first doped structure, the intrinsic region and the second doped structure form a p-i-n structure.

37. A manufacturing method of a solar cell, comprising:
providing an intrinsic semiconductor substrate, wherein the intrinsic semiconductor substrate has a first surface and a second surface that are arranged opposite to each other, a first conductive region and a second conductive region that are arranged in a first direction are provided on the intrinsic semiconductor substrate, and the first direction is perpendicular to a thickness direction of the intrinsic semiconductor substrate;
forming a first passivation layer on the first surface, and forming a first doped structure on a side of the first passivation layer away from the intrinsic semiconductor substrate, wherein the first passivation layer is located in the first conductive region, and the first doped structure has a first doping type; and
forming a second passivation layer on the first surface, and forming a second doped structure on a side of the second passivation layer away from the intrinsic semiconductor substrate;
wherein the second passivation layer is located in the second conductive region, the second doped structure has a second doping type; the first doping type is opposite to the second doping type; and the first doped structure, the intrinsic semiconductor substrate, and the second doped structure form a p-i-n structure.

38. A photovoltaic module, comprising the solar cell according to any one of claims 1 to 35.

39. A photovoltaic system, comprising the photovoltaic module according to claim 38.
